Europäisches Patentamt

European Patent Office

Office européen des brevets

(11) Veröffentlichungsnummer: **0 167 105**
A2

(12) # EUROPÄISCHE PATENTANMELDUNG

(21) Anmeldenummer: 85107923.6

(22) Anmeldetag: 26.06.85

(51) Int. Cl.⁴: **H 03 K 3/353**

(30) Priorität: 02.07.84 DE 3424274

(43) Veröffentlichungstag der Anmeldung:
08.01.86 Patentblatt 86/2

(84) Benannte Vertragsstaaten:
AT DE FR GB IT NL

(71) Anmelder: Siemens Aktiengesellschaft
Berlin und München Wittelsbacherplatz 2
D-8000 München 2(DE)

(72) Erfinder: Schütz, Alfred, Dr.-Ing.
Lindenstrasse 22
D-8011 Zorneding(DE)

(72) Erfinder: Müller, Wolfgang, Dr.-Ing.
Theodor-Heuss-Strasse 12
D-8011 Putzbrunn(DE)

(72) Erfinder: Soutschek, Ewald, Dr.-Ing.
Theodor-Heuss-Strasse 8
D-8011 Putzbrunn(DE)

(54) **Integrierte Schaltung zur Abgabe einer zwischen einem positiven und einem negativen Spannungspegel alternierenden Taktspannung.**

(57) Integrierte Schaltung zur Abgabe einer zwischen einem positiven und einem negativen Spannungspegel alternierenden Taktspannung ($V_A$), die mittels einer unipolaren Taktspannung ($V_E$) ansteuerbar ist. Angestrebt wird eine in einfacher Weise zu realisierende Schaltung, die auf einer möglichst kleinen Halbleiterfläche aufgebaut werden kann. Das wird erreicht durch eine Serienschaltung dreier Feldeffekttransistoren (T1 bis T3), deren endseitige Anschlüsse (1, 2) mit den genannten Spannungspegeln beschaltet sind. Dabei gehören der erste und zweite Feldeffekttransistor (1, 2) jeweils einem ersten und zweiten Kanaltyp an, wobei ihre Gateanschlüsse an einen gemeinsamen Steuereingang (E) gelegt sind, der mit der unipolaren Taktspannung ($V_E$) beaufschlagt ist. Der Verbindungspunkt (3) der ersten beiden Feldeffekttransistoren (T1, T2) bildet den Schaltungsausgang (A) und ist über eine Kapaxität (C) mit dem Gate des dritten Feldeffekttransistors (T3) verbunden, der dem ersten Kanaltyp angehört. Das Gate des dritten Feldeffekttransistors (T3) ist über eine Diode (D) oder einen weiteren Feldeffekttransistor (T4) des ersten Kanaltyps mit dem ihm zugeordneten endseitigen Anschluß (2) der Serienschaltung verbunden, an den auch das Gate des weiteren Feldeffekttransistors (T4) gelegt ist.

FIG 1

EP 0 167 105 A2

Siemens Aktiengesellschaft            Unser Zeichen
Berlin und München                    VPA  84 P 1474 E

Integrierte Schaltung zur Abgabe einer zwischen einem
positiven und einem negativen Spannungspegel alternierenden Taktspannung.

Die Erfindung bezieht sich auf eine integrierte Schaltung zur Abgabe einer zwischen einem positiven und einem
negativen Spannungspegel alternierenden Taktspannung.

Eine Schaltung dieser Art ist aus der DE-A 27 44 209
bekannt. Bei dieser ist ein mit einer unipolaren Taktspannung belegter Schaltungseingang über einen Inverter
und eine diesem nachgeschaltete erste Kapazität mit dem
ersten Eingang eines ersten NOR-Gatters und über eine
zweite Kapazität mit dem ersten Eingang eines zweiten
NOR-Gatters verbunden, wobei jedes dieser Gatter über
seinen Ausgang an den zweiten Eingang des jeweils anderen geschaltet ist. Die ersten Eingänge beider NOR-
Gatter sind weiterhin über Lastelemente an einen den
negativen Spannungspegel führenden Anschluß gelegt,
während der positive Spannungspegel den NOR-Gattern als
Versorgungsspannung zugeführt wird. Einer der Gatterausgänge bildet den Schaltungsausgang. Diese Schaltung ist
allerdings relativ aufwendig.

Der Erfindung liegt die Aufgabe zugrunde, eine integrierte Schaltung der eingangs genannten Art anzugeben,
die einfacher zu realisieren ist als die bekannte
Schaltung und weniger Halbleiterfläche erfordert. Das
wird erfindungsgemäß durch eine Ausbildung derselben
nach dem kennzeichnenden Teil des Patentanspruchs 1
oder des Patentanspruchs 2 erreicht.
St 1 Sti/6.6.1984

Der Vorteil der erfindungsgemäßen Schaltung liegt insbesondere darin, daß eine wesentlich kleinere Anzahl von Schaltungselementen benötigt wird, unter denen sich nur eine Kapazität befindet.

Die Ansprüche 3 bis 5 betreffen vorteilhafte Ausgestaltungen und Weiterbildungen der Erfindung.

Die Erfindung wird nachfolgend anhand der Zeichnung näher erläutert. Dabei zeigt:

Fig. 1 ein erstes Ausführungsbeispiel der Erfindung,

Fig. 2 Spannungs-Zeitdiagramme zur Erläuterung von Fig. 1,

Fig. 3 ein zweites Ausführungsbeispiel der Erfindung und

Fig. 4 eine Weiterbildung der Schaltungen nach Fig. 1 und Fig. 3.

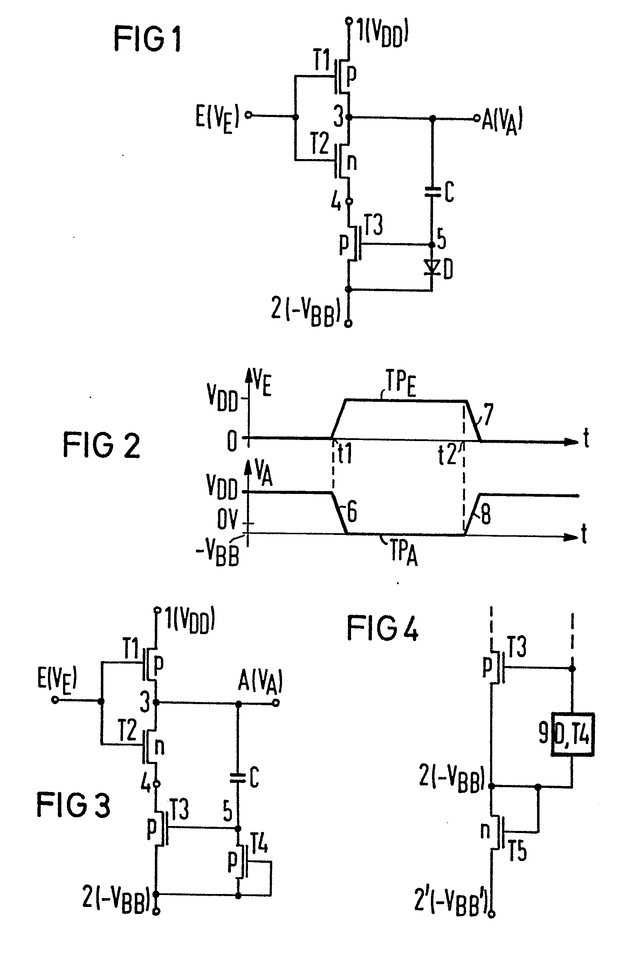

In Fig. 1 ist eine Serienschaltung dreier Feldeffekttransistoren T1 bis T3 dargestellt, von denen T1 und T3 dem p-Kanal-Anreicherungstyp angehören, während T2 ein Transistor des n-Kanal-Anreicherungstyps ist. Endseitige Anschlüsse der Serienschaltung sind mit 1 und 2 bezeichnet, wobei 1 auf der Seite des Feldeffekttransistors T1 liegt bzw. diesem zugeordnet ist, während 2 dem Feldeffekttransistor T3 zugeordnet ist. Die Gateanschlüsse von T1 und T2 sind an einen gemeinsamen Schaltungseingang E gelegt, während der Verbindungspunkt 3 von T1 und T2 einerseits mit dem Schaltungsausgang A und andererseits über eine Kapazität C mit dem Gate von T3 beschaltet ist. Dieses Gate ist über eine Diode D mit dem endseitigen Anschluß 2 verbunden, wobei der anodenseitige Anschluß von D am Gate von T3 liegt.

Wird nun ein positiver Spannungspegel $V_{DD}$ an den endseitigen Anschluß 1 geschaltet und ein negativer Spannungspegel $-V_{BB}$ an den endseitigen Anschluß 2, so ist an A eine Ausgangsspannung $V_A$ abgreifbar, die zwischen diesen beiden Spannungspegeln alterniert, und zwar im Takte einer bei E zugeführten unipolaren Taktspannung $V_E$, die ihrerseits zwischen einem positiven Spannungswert und einem Bezugspotential alterniert.

In Figur 2 ist der zeitliche Verlauf einer solchen Taktspannung $V_E$ dargestellt. Vor dem Erreichen des Zeitpunktes t1 weist sie einen Amplitudenwert 0 Volt auf. Hierbei leitet T1, während T2 sperrt. Der positive Spannungspegel $V_{DD}$ wird vom Anschluß 1 über T1 auf den Ausgang A durchgeschaltet, wie auch aus Fig. 2 hervorgeht. Das Potential des Schaltungspunktes 4 wird über den leitenden Feldeffekttransistor T3 so lange abgesenkt, bis es nur noch um den Wert der Einsatzspannung von T3 oberhalb des Potentials des Schaltungspunkts 5 liegt. Letzteres liegt um den Wert der vorderen Schwellwertspannung der Diode D oberhalb des negativen Spannungspegels $-V_{BB}$ am Anschluß 2. Erreicht der Schaltungspunkt 4 dieses minimale Potential, so sperrt T3.

Durch die zum Zeitpunkt t1 auftretende Anstiegsflanke eines Taktimpulses $TP_E$ von $V_E$ wird das Potential an E auf $V_{DD}$ angehoben, wodurch T1 sperrt, während T2 in den leitenden Zustand geschaltet wird. Über T2 wird sodann das Potential an A zunächst auf den Wert abgesenkt, auf den sich der Schaltungspunkt 4 eingestellt hatte. Der hierbei an A auftretende negative Spannungssprung wird über C auf den Schaltungspunkt 5 übertragen, was zur Folge hat, daß T3 leitend geschaltet wird. Nunmehr verringert sich das Potential an A über die leitenden Transistoren T2 und T3 auf den Wert $-V_{BB}$, was in Fig. 2 durch eine abfallende Flanke 6 der Ausgangsspannung $V_A$ angedeutet wird. Der negative Amplitudenwert $-V_{BB}$ der Ausgangsspannung $V_A$ bleibt dann bestehen, bis zum Zeitpunkt t2 die abfallende Flanke 7 des Taktimpulses $TP_E$ einsetzt. Diese verschiebt das Potential an E wieder auf 0 Volt, so daß T2 sperrt, während T1 leitet. Das Potential an A wird über den leitenden Transistors T1 auf $V_{DD}$ angehoben, was in Fig. 2 durch die Flanke 8 angedeutet ist. Der hierbei an A auftretende positive Spannungssprung wird über C auf den Schaltungspunkt 5 übertragen, wobei T3 sperrt. Durch den sich am Schaltungspunkt 5 ergebenden positiven Spannungssprung wird die Diode D leitend geschaltet, was wieder zu einer Verringerung des Potentials an 5 über die Diode D auf einen minimalen Wert führt, der sich nur noch um den Wert der vorderen Schwellwertspannung von D von $-V_{BB}$ unterscheidet. Ist dieser minimale Wert erreicht, so sperrt D. Damit ist der Ausgangszustand wieder eingestellt.

Fig. 2 zeigt, daß mit der Schaltung nach Fig. 1 ein Taktimpuls $TP_A$ der Ausgangsspannung $V_A$ erzeugt wird, wobei diese von dem positiven Spannungspegel $V_{DD}$ auf den negativen Spannungspegel $-V_{BB}$ umgeschaltet und wieder rückgeschaltet wird. Die Umschaltung bzw. Rückschaltung erfolgt gleichzeitig mit dem Auftreten der vorderen und rückwärtigen Flanke des unipolaren Taktimpulses $TP_E$, d.h. zu den Zeitpunkten t1 und t2. Weist die Taktspannung $V_E$ eine Reihe von Taktimpulsen $TP_E$ auf, so tritt an A eine Taktspannung mit einer entsprechenden Anzahl von Taktimpulsen $TP_A$ auf.

Fig. 3 zeigt ein zweites Ausführungsbeispiel der Erfindung, das sich von Fig. 1 nur dadurch unterscheidet,
daß an die Stelle von D ein weiterer Feldeffekttransistor T4 des p-Kanal-Anreicherungstyps tritt, der
zwischen das Gate von T3 und den endseitigen Anschluß 2
geschaltet ist, wobei sein Gate an den Anschluß 2 gelegt
ist. Die übrigen Schaltungsteile entsprechen denen von
Fig. 1 und sind mit den gleichen Bezugszeichen versehen.

Die Wirkungsweise der Schaltung nach Fig. 3 entspricht
der der Schaltung nach Fig. 1, wobei der Feldeffekttransistor T4 immer dann leitend geschaltet wird, wenn infolge der Flanke 8 von $V_A$ auf den Schaltungspunkt 5 ein
positiver Spannungssprung übertragen wird. Über den
leitenden Transistor T4 wird hieran anschließend das
Potential an 5 auf einen minimalen Wert abgesenkt, der
um den Wert der Einsatzspannung von T4 höher ist als das
Potential $-V_{BB}$ am endseitigen Anschluß 2. Der mit T4
erreichbare minimale Potentialwert am Spannungspunkt 5
entspricht etwa dem mit der Diode D erreichbaren Minimalwert.

Nach der in Fig. 4 gezeigten Weiterbildung der Erfindung
ist der endseitige Anschluß 2 gemäß den Figuren 1 oder 3
über die Source-Drain-Strecke eines zusätzlichen Feldeffekttransistors T5 des n-Kanal-Anreicherungstyps mit
einem zusätzlichen Anschluß 2' verbunden, der mit einem
negativen Spannungspegel $-V_{BB}$' beschaltet ist. Der Block
9 soll für den Fall, daß von einer Schaltung nach Fig. 1
ausgegangen wird, die Diode D darstellen, während er im
Fall einer Schaltung nach Fig. 3 den Transistor T4 andeutet. Das Gate von T5 ist mit dem Anschluß 2 verbunden. Wenn das Potential $-V_{BB}$' an 2' so gewählt ist, daß
es um den Wert der Einsatzspannung von T5 negativer ist
als das obengenannte Potential $-V_{BB}$, so stellt sich $-V_{BB}$

am Anschluß 2 von Fig. 4 ein, wobei sich auch nach Fig. 4 die bisher beschriebene Ausgangsspannung $V_A$ in Abhängigkeit von $V_E$ ergibt. Zum Unterschied von den Figuren 1 und 3 hat man nun jedoch einen negativen Spannungspegel $-V_{BB}'$ zur Verfügung, der um die Einsatzspannung von T5 negativer ist als der minimale Wert der Ausgangsspannung $V_A$, der gemäß Fig. 2 dem Potential $-V_{BB}$ entspricht. Legt man das Substrat, auf dem die integrierte Schaltung nach der Erfindung aufgebaut ist, auf das Potential $-V_{BB}'$, so kann die Ausgangsspannung $V_A$ auch bei einer Überlagerung von Störspannungen, die in ihrer Amplitude den Wert der Einsatzspannung von T5 nicht überschreiten, niemals negativer werden als die Substratvorspannung $-V_{BB}'$. Hierdurch wird mit großer Sicherheit vermieden, daß die pn-Übergänge zwischen einzelnen n-leitenden Halbleiterzonen, in denen sich die p-Kanal-Feldeffekttransistoren der Schaltung befinden, und dem p-leitenden Substrat in Durchlaßrichtung vorgespannt werden, was eine Verschlechterung der Isolation zwischen einzelnen Schaltungsteilen zur Folge hätte.

Neben den bisher beschriebenen Ausführungsformen sind auch weitere von Interesse, bei denen dem Eingang E eine unipolare Taktspannung zugeführt wird, die zwischen einem negativen Spannungspegel und dem Bezugspotential alterniert. Hierbei sind die Feldeffekttransistoren T1, T3 und gegebenenfalls T4 als solche des n-Kanal-Anreicherungstyps ausgebildet, während T2 und gegebenenfalls T5 dem p-Kanal-Anreicherungstyp angehören. Der negative Spannungspegel $-V_{BB}$ wird in diesem Fall dem Anschluß 1 zugeführt, während der positive Spannungspegel $V_{DD}$ an den Anschluß 2 gelegt ist. Die Ausgangsspannung $V_A$ erhält dann einen zur Darstellung nach Fig. 2 inversen Verlauf, wobei vor dem Zeitpunkt t1 ein Amplitudenwert $-V_{BB}$ auftritt, der dann nach t1 auf den Wert $V_{DD}$ umgeschaltet wird, wobei weiterhin nach t2 wieder eine Rückschaltung auf $-V_{BB}$ erfolgt. Der Spannungspegel $-V_{BB}'$ am Schaltungspunkt 2' von Fig. 4 wird bei diesen weiteren Ausführungsformen durch einen Spannungspegel $V_{DD}'$ ersetzt, der um den Betrag der Einsatzspannung von T5 positiver ist als $V_{DD}$.

Ein wichtiger Anwendungsfall der erfindungsgemäßen Schaltung ist die Erzeugung einer Spannung, die zwischen einem positiven Spannungspegel, z.B. 5 Volt, und einem negativen Spannungspegel, z.B. -2 Volt, alterniert und an die Wortleitungen von RAM-Halbleiterspeichern zur Selektion einzelner Speicherzellen gelegt wird. Die über die Wortleitungen ansteuerbaren p-Kanal-Auswahltransistoren der einzelnen Speicherzellen werden beim Auftreten des -2-Volt-Pegels dieser Spannung leitend geschaltet, während sie beim Auftreten des 5-Volt-Pegels gesperrt sind. Dabei wird der Speicherkondensator jeder selektierten Speicherzelle über ihren leitend geschalteten Auswahltransistor mit einer zugeordneten Bitleitung verbunden. Nimmt man an, daß die Bitleitung auf 0 Volt liegt, so kann bei einer über die Wortleitung zugeführten Spannung von z.B. -2 Volt am Gate des p-Kanal-Auswahltransistors der vorher auf 5 Volt aufgeladene Speicherkondensator ohne Schwierigkeiten bis auf 0 Volt entladen werden. Würde dagegen das Gate des Auswahltransistors mit einer Spannung von 0 Volt beaufschlagt werden, so wäre bei sonst gleichen Verhältnissen eine Entladung des Speicherkondensators nur auf eine Spannung auf etwa 1 Volt möglich, da dann der Auswahltransistor (bei einer Einsatzspannung von etwa 1 Volt) bereits sperren würde. Hier ist es ein großer Vorteil, daß eine zwischen 5 Volt und 0 Volt alternierende Spannung auf der Wortleitung durch eine solche ersetzt wird, die zwischen 5 Volt und -2 Volt alterniert.

5 Patentansprüche
4 Figuren

## Patentansprüche

1. Integrierte Schaltung zur Abgabe einer zwischen einem positiven und einem negativen Spannungspegel alternierenden Taktspannung, d a d u r c h   g e - k e n n z e i c h n e t , daß eine Serienschaltung dreier Feldeffekttransistoren (T1, T2, T3) vorgesehen ist, deren endseitige Anschlüsse (1, 2) mit den genannten Spannungspegeln beschaltet sind, daß der erste und zweite Feldeffekttransistor (T1, T2) dieser Serienschaltung jeweils einem ersten und zweiten Kanaltyp angehören und mit ihren Gateanschlüssen an einen gemeinsamen, mit einer unipolaren Taktspannung beaufschlagten Steuereingang (E) gelegt sind, während ihr Verbindungspunkt (3) an den Schaltungsausgang (A) geführt ist und über eine Kapazität (C) mit dem Gate des dritten Feldeffekttransistors (T3) verbunden ist, der dem ersten Kanaltyp angehört, und daß das Gate des dritten Feldeffekttransistors (T3) über eine Diode (D) mit dem ihm zugeordneten, endseitigen Anschluß (2) der Serienschaltung verbunden ist.

2. Integrierte Schaltung zur Abgabe einer zwischen einem positiven und einem negativen Spannungspegel alternierenden Taktspannung, d a d u r c h   g e k e n n z e i c h - n e t , daß eine Serienschaltung dreier Feldeffekttransistoren (T1, T2, T3) vorgesehen ist, deren endseitige Anschlüsse (1, 2) mit den genannten Spannungspegeln beschaltet sind, daß der erste und zweite Feldeffekttransistor (T1, T2) dieser Serienschaltung jeweils einem ersten und zweiten Kanaltyp angehören und mit ihren Gateanschlüssen an einen gemeinsamen, mit einer unipolaren Taktspannung beaufschlagten Steuereingang (E) gelegt sind, während ihr Verbindungspunkt (3) an den Schaltungsausgang (A) geführt ist und über eine Kapazität (C) mit dem Gate des dritten Feldeffekttransistors (T3) verbunden ist, der dem ersten Kanaltyp angehört, und daß das Gate des dritten Feldeffekttransistors (T3) über einen weiteren Feldeffekttransistor (T4) des ersten Kanaltyps mit dem ihm zugeordneten, endseitigen Anschluß (2) der Serienschaltung verbunden ist, an den auch das Gate des weiteren Feldeffekttransistors (T4) geschaltet ist.

3. Integrierte Schaltung nach Anspruch 1 oder 2, d a - d u r c h   g e k e n n z e i c h n e t , daß der positive Spannungspegel an den dem ersten Feldeffekttransistor (T1) zugeordneten endseitigen Anschluß (1) der Serienschaltung gelegt ist, daß der erste, dritte und gegebenenfalls der weitere Feldeffekttransistor (T1, T3, T4) dem p-Kanal-Anreicherungstyp und der zweite (T2) dem n-Kanal-Anreicherungstyp angehören und daß die unipolare Taktspannung zwischen einem positiven Spannungswert und dem Bezugspotential alterniert.

4. Integrierte Schaltung nach Anspruch 1 oder 2, d a - d u r c h   g e k e n n z e i c h n e t , daß der negative Spannungspegel an den dem ersten Feldeffekttransistor (T1) zugeordneten endseitigen Anschluß (1) der Serienschaltung gelegt ist, daß der erste, dritte und gegebenenfalls der weitere Feldeffekttransistor (T1, T3, T4) dem n-Kanal-Anreicherungstyp und der zweite dem p-Kanal-Anreicherungstyp angehören und daß die unipolare Taktspannung zwischen einem negativen Spannungswert und dem Bezugspotential alterniert.

5. Integrierte Schaltung nach einem der Ansprüche 1 bis 4, d a d u r c h   g e k e n n z e i c h n e t , daß der dem dritten Feldeffekttransistor (T3) zugeordnete endseitige Anschluß (2) der Serienschaltung mit der Source-Drain-Strecke eines zusätzlichen Feldeffekttransistors (T5) des zweiten Kanaltyps beschaltet ist, über
den ein anderer Spannungspegel zugeführt wird, und daß
das Gate des zusätzlichen Feldeffekttransistors (T5) mit
diesem endseitigen Anschluß (2) der Serienschaltung
verbunden ist.

0167105

1/1

FIG 1

FIG 2

FIG 3

FIG 4